Europäisches Patentamt

European Patent Office

Office européen des brevets

(19)

(11) **EP 0 742 441 A1**

(12) **DEMANDE DE BREVET EUROPEEN**

(43) Date de publication:
**13.11.1996 Bulletin 1996/46**

(51) Int Cl.$^6$: **G01R 15/20**

(21) Numéro de dépôt: **96400906.2**

(22) Date de dépôt: **26.04.1996**

(84) Etats contractants désignés:
**DE GB**

(30) Priorité: **12.05.1995 FR 9505659**

(71) Demandeur: **THOMSON-CSF**
**75008 Paris (FR)**

(72) Inventeurs:
- **Schuhl, Alain**
  **92402 Courbevoie Cedex (FR)**
- **Nguyen-Van-Dau, Frédéric**
  **92402 Courbevoie Cedex (FR)**

(54) **Ampèremètre**

(57) Cet ampèremètre comprend:

- un élément (1) en matériau magnétorésistif en couche mince situé sur une première face (10) d'un substrat ; - des premiers moyens de connexion (2', 2") connectés à l'élément magnétorésistif (1) en deux zones situées selon une première direction (XX') et permettant une alimentation en courant (i) de l'élément (1);

- des deuxièmes moyens de connexion (3', 3") connectés à l'élément (1) magnétorésistif en deux zones situées selon une deuxième direction (YY') perpendiculaire à la première direction (XX').

Cet ampèremètre permet de mesurer la valeur du courant circulant dans un conducteur orienté de préférence selon une direction (ZZ') parallèle à la première direction (XX').

FIG. 2

**Description**

L'invention concerne un ampèremètre et plus particulièrement un ampèremètre comportant un élément magnétosensible à effet Hall planaire. Elle est applicable également à un disjoncteur différentiel.

La demande de brevet français n° 93 15551 décrit un senseur de champ magnétique faible à base d'un élément magnétosensible à effet Hall planaire.

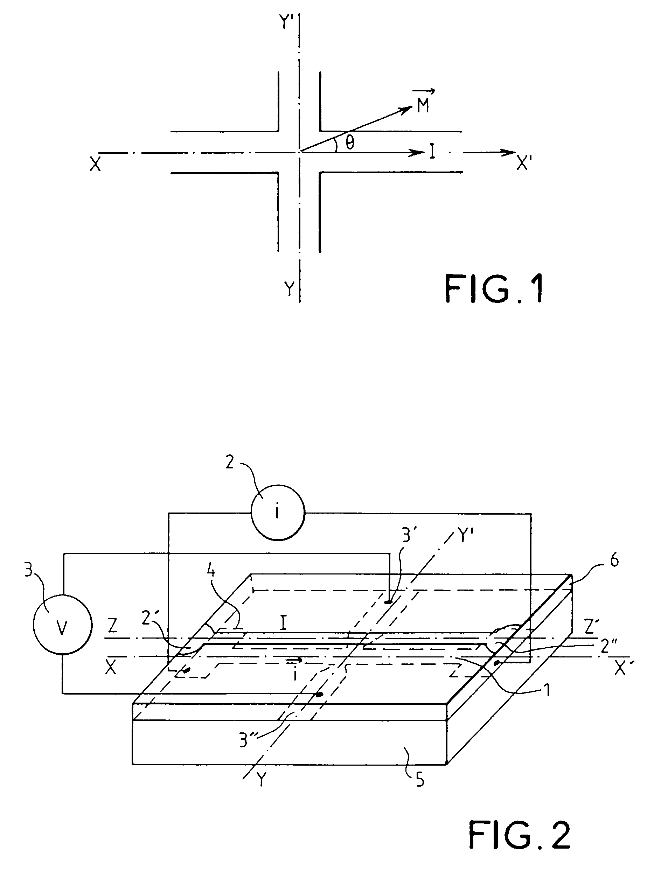

Un tel senseur repose sur la mesure transverse de l'effet de magnétorésistance anisotrope dans un film mince ferromagnétique. La figure 1 représente la couche magnétosensible. Un courant I circule selon une direction XX' de la couche et on mesure la résistivité selon la direction YY'. Cette résistivité varie en fonction de l'aimantation M appliquée au senseur. De plus, elle est fonction de l'angle θ entre l'aimantation et la direction XX' du courant :

$$\rho = \frac{\Delta\rho}{2} \sin 2\theta$$

Les deux principaux avantages des capteurs à effet Hall planaire par rapport aux capteurs magnétorésistifs à mesure longitudinale sont d'une part une grande simplification de la technologie associée, d'autre part une réduction d'environ quatre ordres de grandeur de la dérive thermique, principale composante de bruit à faible fréquence (autour de 1 Hz). Par construction, ce capteur peut être rendu sensible uniquement à la composante du champ magnétique perpendiculaire à sa direction d'alimentation. Sa taille peut être réduite jusqu'à des dimensions inférieures à celle des domaines magnétiques, ce qui permet d'éliminer la source de bruit associée aux mouvements de parois. Nous avons mesuré, sur des prototypes de tels capteurs, une réponse linéaire sur quatre ordres de grandeurs (voir document A. Schuhl, F. Nguyen-Van-Dau and J.R. Childress, Applied Physics Letters, 66 15 Mai 1995).

L'invention concerne donc un ampèremètre comprenant :

- un élément en matériau magnétorésistif en couche mince situé sur une première face d'un substrat;
- des premiers moyens de connexion connectés à l'élément magnétorésistif en deux zones situées selon une première direction (XX') et permettant une alimentation en courant de l'élément ;
- des deuxièmes moyens de connexion connectés à l'élément magnétorésistif en deux zones situées selon une deuxième direction (YY') perpendiculaire à la première direction.

Les différents objets et caractéristiques de l'invention apparaîtront plus clairement dans la description qui va suivre et dans les figures annexées qui représentent:

- la figure 1, un dispositif à effet Hall planaire déjà décrit précédemment ;
- la figure 2, un exemple de réalisation d'un dispositif selon l'invention ;
- la figure 3, une courbe de réponse d'un ampèremètre selon l'invention ;
- la figure 4, une variante de l'ampèremètre de la figure 2 ;
- les figures 5a à 5c, des moyens de mise en position d'un conducteur dont on veut mesurer le courant ;
- la figure 6, un circuit d'ampèremètre différentiel ;
- les figures 7a et 7b, un ampèremètre différentiel plus compact appliquant l'ampèremètre selon l'invention ;
- la figure 8, un ampèremètre à plusieurs capteurs ne nécessitant pas de dispositif de mise en place du conducteur.

En se reportant à la figure 2, on va donc décrire un exemple de réalisation d'un ampèremètre selon l'invention.

Un substrat 5 porte un élément 1, de préférence carré mais pouvant être rectangulaire, en couche mince d'un matériau magnétorésistif permettant d'obtenir un effet Hall planaire. De préférence, ce matériau présente une anisotropie orientée dans le plan de la couche. A titre d'exemple, l'épaisseur de la couche est comprise entre 0,01 et 1 μm (0,02 μm par exemple) et la largeur et la longueur de l'élément 1 sont comprises entre 10 et 50 μm (20 μm par exemple). Selon un axe XX' l'élément 1 possède à ces deux extrémités des plages de connexion 2', 2" permettant de connecter un appareil d'alimentation en courant 2 permettant la circulation d'un courant i dans l'élément 1. Ce courant i est de préférence continu et constant.

Deux éléments de connexion 3' et 3" sont connectés de part et d'autre de l'élément 1 selon un axe YY' perpendiculaire à l'axe XX'. Ces éléments de connexion permettent de connecter un appareil de mesure 3 de tension ou de résistivité. Les plages de connexions 2', 2" et 3', 3" font chacune la largeur d'un côté de l'élément 1. De plus, on prévoit une augmentation rapide de la largeur de ces plages de connexion pour diminuer les limitations liées au bruit de Johnson ainsi que la dissipation électrique.

L'élément 1 est recouvert d'une couche d'isolant 6.

Sur la couche d'isolant est prévu des moyens pour permettre la circulation d'un courant I à mesurer tel qu'un conducteur 4.

La circulation d'un courant électrique dans le conducteur 4 (continu ou alternatif) génère un champ magnétique transversal (selon la direction ZZ') qui peut être détecté par le capteur. Comme nous le verrons dans le calcul d'ordre de grandeur ci-dessous, il est avantageux de se placer dans la limite ou le conducteur est large vis-à-vis de la distance le séparant de la couche sensible 1 du capteur. Le choix de l'isolant séparant le conducteur 4 de la couche 1 dépend de la gamme de courant à mesurer. Cet isolant peut soit être une couche déposée sur la couche 1 soit être un espace libre calibré. La seule contrainte est que le fil doit être parallèle à la direction d'alimentation du capteur de telle manière que le champ magnétique associé à la circulation d'un courant électrique dans ce conducteur ait au moins une composante transversale au niveau du capteur. En particulier, il n'est pas nécessaire que ce conducteur soit situé à l'aplomb du capteur comme cela est indiqué sur la figure 2.

Le calcul de l'amplitude du champ magnétique induit au niveau du capteur par un courant de mesure d'amplitude I, conduit à l'expression :

$$B = (\mu_0 I / \pi L) * Arctg( L / 2D)$$

où :

- L est la largeur du conducteur 4 transportant le courant à mesurer ;
- D est la distance entre le conducteur 4 et la couche 1.

Lorsque L2D>>1, on a B~$\mu_0$I/2L.

Ainsi dans le cas limite où L » 2D la sensibilité de l'ampèremètre est indépendante de la distance entre la ligne de courant 4 et l'élément sensible 1.

Pour se rendre compte de l'intérêt de l'invention nous donnons ici deux exemples d'applications de l'invention correspondant à deux géométries distinctes avec un même élément sensible détectant des champs magnétiques compris entre 10 nT et 1 mT.

A titre d'exemple, nous considérons ci-dessous deux configurations possibles :

Géométrie 1 : L = 300 µm et D = 1 µm conduisent à B/I = 2.1 mT/A = 21 mG/mA

Géométrie 2 : L = 1 cm et D = 1 mm conduisent à B/I = 3.15 $10^{-5}$T/A = 0.315G/A

Un capteur dans la géométrie 1 mesurera des courants allant de 5µA à 500 mA. Un capteur dans la géométrie 2 mesurera des courants allant de 300 µA à 30A. Pour une sensibilité typique du capteur de 100 V/T.A et une alimentation de la couche 1 du capteur par un courant de 10 mA, on aboutit à une sensibilité de l'ampèremètre de 2,1 mV/A pour la géométrie 1 et 31.5 µV/A pour la géométrie 2.

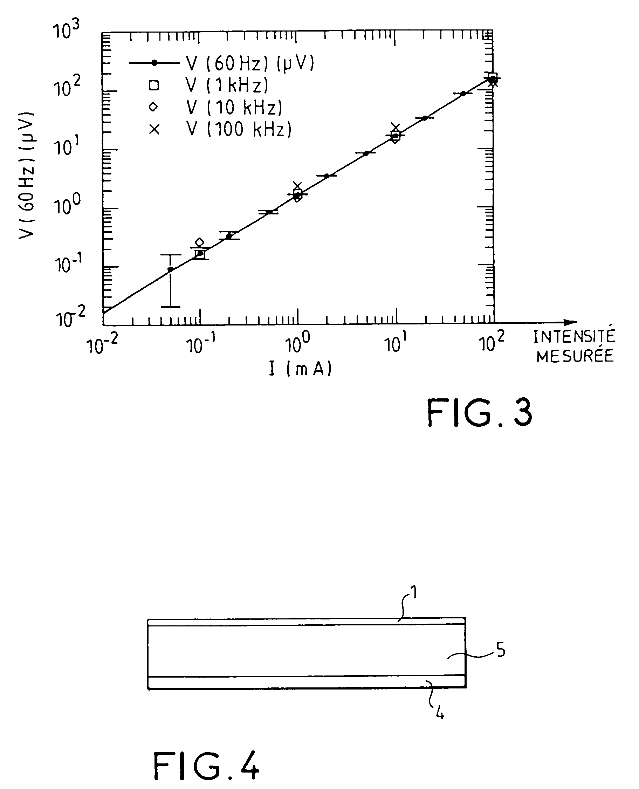

La courbe de la figure 3 représente un exemple de réponse d'un ampèremètre selon l'invention.

La figure 4 représente une variante de réalisation selon l'invention dans laquelle le conducteur 4 est située sur la face du substrat 5 opposée à celle portant l'élément 1. Le substrat doit alors être isolant et son épaisseur détermine la distance D séparant l'élément 1 du conducteur 4.

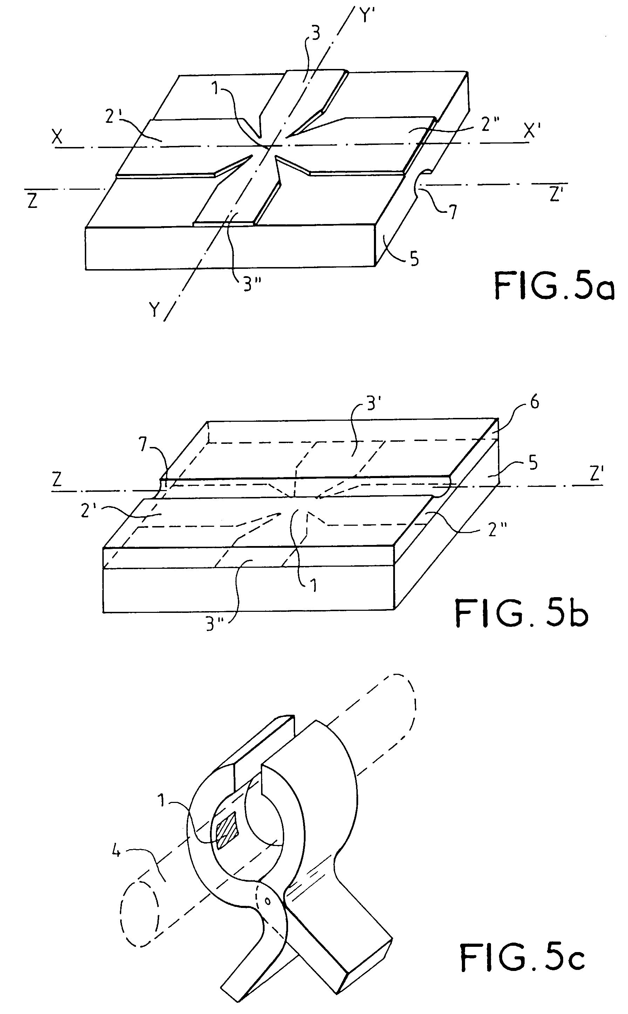

On peut réaliser à l'aide d'un capteur à effet Hall planaire ainsi décrit un ampèremètre sans contact, c'est-à-dire un dispositif permettant de mesurer le courant circulant dans un élément de circuit électrique (par exemple un fil) sans avoir à se brancher sur celui-ci. Pour cela comme représenté en figures 5a et 5b, on prévoit un logement mécanique de l'élément de circuit 4 permettant une distance contrôlée du capteur. Par exemple, la figure 5a prévoit sur la face arrière du substrat opposée à l'élément 1, des moyens permettant de positionner selon l'axe ZZ', un conducteur dans lequel circule un courant dont on doit mesurer l'intensité I. Ces moyens de positionnement peuvent être des repères dessinés sur le substrat. Selon la figure 5a, on a prévu une gorge 7 dans laquelle on vient placer le conducteur. On aurait pu également prévoir des bossages au lieu de la gorge.

La figure 5b est une variante de la figure 5a selon laquelle la gorge 7 est située dans la couche d'isolant 6.

Le problème associé à la méconnaissance de la dimension transversale L de l'élément de circuit 4 ou au fait que cette dimension puisse ne pas être nettement supérieure à la distance entre l'élément et le capteur peut être résolu en disposant plusieurs capteurs transversalement par rapport à la circulation du courant à mesurer. La mesure effectuée sur chacun des capteurs et la connaissance de la distance les séparant permet de remonter aux deux inconnues : la dimension latérale de l'élément de circuit et l'intensité du courant.

Cette amélioration permet une mesure plus précise du courant dans le cas d'un fil dont la taille (diamètre du fil + gaine) est du même ordre de grandeur que la distance entre le fil et le capteur.

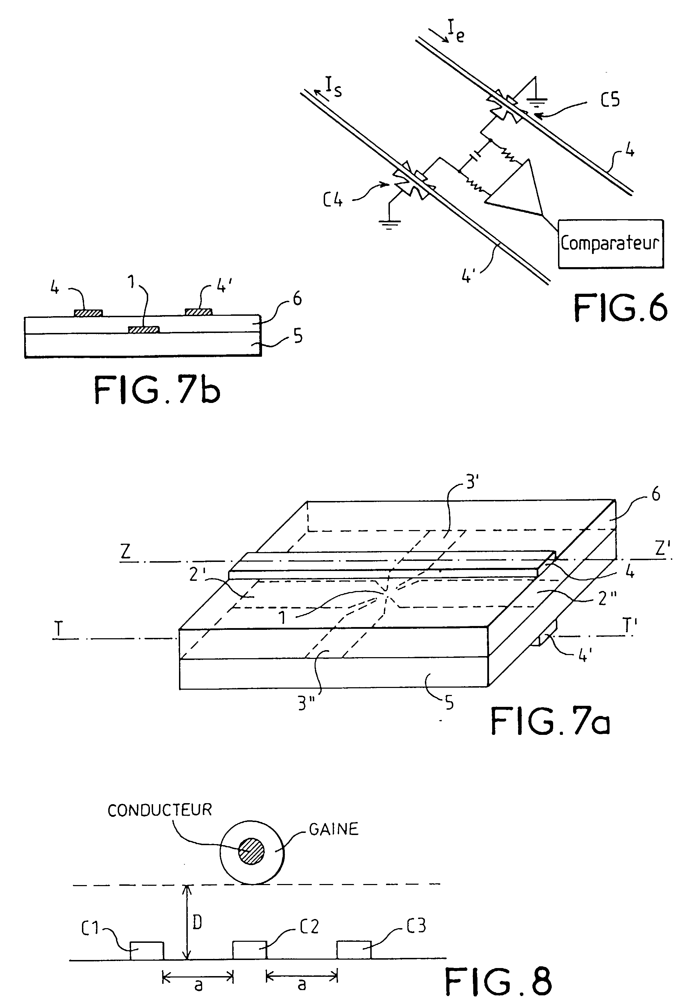

La figure 8 montre un exemple particulier avec trois capteurs C1, C2, C3 placés côte à côte sur un substrat.

Le fonctionnement d'un tel dispositif est le suivant. On bouge l'ensemble de capteurs jusqu'à obtenir une réponse identique sur C1 et sur C3. Le courant I à mesurer est alors donné par :

$$I = \frac{\pi B_2}{\mu_0} \frac{a}{\sqrt{\dfrac{B_2}{B_3} - 1}}$$

où "a" est la distance entre les deux capteurs (C1-C2 et C2-C3) et B2 et B3 la réponse des capteurs C2 et C3.

Pour des questions de commodité d'utilisation, l'ampèremètre peut être réalisé sous forme d'une pince 7 telle qu'une pince ampèremétrique (figure 5c), permettant de mettre en place le conducteur devant l'élément sensible 1 de l'ampèremètre qui est alors situé dans une branche de la pince à proximité du conducteur 4.

Selon une forme de réalisation plus générale et plus sommaire, on peut également ne pas prévoir de moyen de mise en position du conducteur dont on veut mesurer le courant. On se borne alors à mettre la partie sensible de l'ampèremètre (l'élément 1) à proximité du conducteur et on le fait tourner de façon à obtenir une valeur maximale de la tension (ou de la résistivité). Cette valeur maximale donnant la valeur de mesure.

L'invention concerne aussi la mesure différentielle de deux courants circulant dans deux conducteurs.

La figure 6 représente un ampèremètre permettant de réaliser une mesure différentielle de courant dans deux conducteurs 4 et 4', dans lesquels circulent des courants d'intensités le et ls, avec les capteurs C4 et C5.

Les intensités des courants le et ls sont mesurées séparément, chacune à l'aide de deux capteurs décrits précédemment. Les signaux de sortie des capteurs sont alors éventuellement amplifiés avant d'être comparés.

Les applications de cette invention concernent en particulier les disjoncteurs différentiels. La mesure de la différence d'intensité entre la ligne d'arrivée (le) et la sortie de sortie (ls) permet de détecter les fuites et donc de couper l'arrivée du courant.

L'invention s'applique aussi bien aux installations en courant continu (électronique, navigation) et/ou installation en courant alternatif.

La figure 7a est une façon de réaliser un ampèremètre différentiel et est dérivé du mode de réalisation de la figure 2. Il comporte de chaque côté du capteur, un conducteur 4 et 4'. Le conducteur 4 est localisé sur la couche d'isolant 6 et le conducteur 4' est localisé sur la face du substrat 5 opposée à celle portant l'élément sensible 1. La couche d'isolant 3 et le substrat 5 ont même épaisseur pour que les conducteurs 4, 4' soient à la même distance de l'élément 1. On prévoit que les courants qui circulent dans les conducteurs 4 et 4' soient de sens opposés et soient en phase. Si ces conditions sont respectées, et que les courant sont égaux, les champs magnétiques induits par ces courants s'annulent dans l'élément 1. Par contre, s'ils ne sont pas égaux, le champ magnétique du courant le plus fort prédomine et une tension non nulle est détectée aux bornes 3-3'.

Selon une variante de réalisation représenté en figure 7b, un ampèremètre différentiel peut être également réalisé en prévoyant les conducteurs 4 et 4' sur la même face du capteur, par exemple sur la couche d'isolant 6. Les conducteurs 4 et 4' sont alors positionnés de façon à être à une même distance de l'élément sensible 1 du capteur.

## Revendications

1. Ampèremètre comprenant :

   - un élément (1) en matériau magnétorésistif en couche mince situé sur une première face (10) d'un substrat ;
   - des premiers moyens de connexion (2', 2") connectés à l'élément magnétorésistif (1) en deux zones situées selon une première direction (XX') et permettant une alimentation en courant (i) de l'élément (1) ;
   - des deuxièmes moyens de connexion (3', 3") connectés à l'élément (1) magnétorésistif en deux zones situées selon une deuxième direction (YY') perpendiculaire à la première direction (XX').

2. Ampèremètre selon la revendication 1, caractérisé en ce qu'il comporte des premiers moyens pour permettre la circulation d'un premier courant (I) à mesurer selon une troisième direction (ZZ') sensiblement parallèle à la première direction (XX') et à proximité de l'élément (1) magnétorésistif.

3. Ampèremètre selon la revendication 2, caractérisé en ce que les moyens permettant la circulation du courant à mesurer comprennent un conducteur (4) muni de moyen de connexion pour la connexion d'un circuit extérieur.

4. Ampèremètre selon la revendication 3, caractérisé en ce que la couche magnétorésistive est située sur une première face (10) d'un substrat (5) et que le conducteur (4) est situé sur une deuxième face de substrat (10') opposée à la première face.

5. Ampèremètre selon la revendication 3, caractérisé en ce que la couche magnétorésistive est recouverte d'une couche isolante (6) et que le conducteur (4) est situé sur cette couche isolante.

6. Ampèremètre selon la revendication 1, caractérisé en ce qu'il comporte des moyens pour permettre la mise en position d'un conducteur selon une troisième direction (ZZ') sensiblement parallèle à la première direction (XX') et à proximité de la couche magnétorésistive (1).

7. Ampèremètre selon l'une des revendications 4, 5 ou 6, caractérisé en ce que la deuxième face (10') du substrat ou la couche isolante (6) comporte des moyens de calage du conducteur (4) dans une position correspondant à la troisième direction (ZZ').

8. Ampèremètre selon la revendication 7, caractérisé en ce que les moyens de calage comportent une rainure.

9. Ampèremètre selon la revendication 7, caractérisé en ce qu'il comporte une pince permettant d'enfermer le conducteur (4) entre les branches de la pince, l'une des branches de la pince comportant l'élément matériau magnétorésistif (1).

10. Ampèremètre selon la revendication 2, caractérisé en ce qu'il comporte des deuxièmes moyens pour permettre la circulation d'un deuxième courant (I') selon une quatrième direction (TT') parallèle à la troisième direction, ces premiers moyens et ces deuxièmes moyens étant à une même distance de l'élément magnétorésistif (1).

**11.** Ampèremètre selon la revendication 10, caractérisé en ce que les premiers et deuxièmes moyens sont situés de part et d'autre de l'élément magnétorésistif (1).

**12.** Ampèremètre selon la revendication 2, caractérisé en ce qu'il comporte :

- un autre élément magnétorésistif (1") en couche mince muni également de moyens de connexion ;
- des moyens pour permettre la circulation d'un deuxième courant (I") selon une autre direction parallèle à celle de cet autre élément (1") et à proximité de cet élément ;
- des moyens de comparaison pour comparer les résultats de mesures de tension effectuées aux moyens de connexion (tels que 3', 3") des deux éléments magnétorésistifs (1, 1').

**13.** Ampèremètre selon la revendication 1, caractérisé en ce que le matériau de l'élément magnétorésistif (1) possède une anisotropie qui maintient la direction de l'aimantation du matériau dans une direction d'un plan parallèle à la première face du substrat (5).

**14.** Ampèremètre selon la revendication 1, caractérisé en ce que l'élément magnétorésistif a pour épaisseur environ 0,01 à 1 µm, pour largeur selon la deuxième direction (YY'), 10 à 50 µm, et en ce que la largeur des moyens de connexions selon la première direction (XX') est d'environ 10 à 50 µm.

FIG.1

FIG.2

FIG. 3

FIG. 4

FIG.5a

FIG.5b

FIG.5c

FIG.6

FIG.7b

FIG.7a

CONDUCTEUR
GAINE

FIG.8

# EP 0 742 441 A1

Office européen
des brevets

**RAPPORT DE RECHERCHE EUROPEENNE**

Numero de la demande

EP 96 40 0906

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-5 172 052 (WELLS)<br>* revendication 1; figure 3 *<br>--- | 1 | G01R15/20 |
| A | US-A-3 693 085 (BEARD)<br>* revendication 1; figure 3B *<br>----- | 1 | |

DOMAINES TECHNIQUES RECHERCHES (Int.Cl.6)

G01R

Le présent rapport a été établi pour toutes les revendications

| Lieu de la recherche | Date d'achèvement de la recherche | Examinateur |
|---|---|---|
| LA HAYE | 12 Juillet 1996 | Hoornaert, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

10